## Europäisches Patentamt

## European Patent Office

## Office européen des brevets

(19)

(11) Veröffentlichungsnummer : **0 508 030 B1**

(12)

# EUROPÄISCHE PATENTSCHRIFT

(45) Veröffentlichungstag der Patentschrift :
08.06.94 Patentblatt 94/23

(51) Int. Cl.$^5$ : **G01R 31/36**

(21) Anmeldenummer : **91810262.5**

(22) Anmeldetag : **10.04.91**

(54) Verfahren und Vorrichtung zum Prüfen des Ladezustands von Starterbatterien.

(43) Veröffentlichungstag der Anmeldung :
14.10.92 Patentblatt 92/42

(45) Bekanntmachung des Hinweises auf die
Patenterteilung :
08.06.94 Patentblatt 94/23

(84) Benannte Vertragsstaaten :
DE FR GB IT

(56) Entgegenhaltungen :
EP-A- 0 206 503
DE-A- 547 815
DE-A- 2 742 675
DE-A- 2 823 413

(73) Patentinhaber : **Callahan, George Edgar**
**Feldstrasse 34**
**D-40479 Düsseldorf (DE)**
Patentinhaber : **Koch, Harald**
**Windscheidstrasse 28**
**D-40239 Düsseldorf (DE)**

(72) Erfinder : **Callahan, George Edgar**
**Feldstrasse 34**
**D-40479 Düsseldorf (DE)**
Erfinder : **Koch, Harald**
**Windscheidstrasse 28**
**D-40239 Düsseldorf (DE)**

(74) Vertreter : **Ryffel, Rolf**
**Hepp, Wenger & Ryffel AG**
**Bahnhofstrasse 58**
**CH-8001 Zürich (CH)**

EP 0 508 030 B1

## Beschreibung

Die Erfindung bezieht sich auf ein Verfahren mit geeigneter Vorrichtung zur Prüfung des Ladezustands von elektrischen Akkumulatoren, insbesondere Starterbatterien in Kraftfahrzeugen.

Der Ladezustand eines Blei-Akkumulators lässt sich zuverlässig mittels Säureprüfung bestimmen. Voll verschlossene, sogenannte "wartungsfreie" Batterien sind hierfür jedoch nicht zugänglich, so dass allein eine elektrische Prüfung möglich ist. In der bisherigen Praxis wurden verschiedene Verfahren verwendet oder vorgeschlagen.

Nach einem ersten herkömmlichen Verfahren wird die Polspannung der unbelasteten Batterie zu einem Zeitpunkt gemessen, da sich die Batterie im elektrochemischen Gleichgewicht befindet. Da zwischen dieser sogenannten "Ruhespannung" und der Säuredichte der Batterie eine etwa lineare Beziehung besteht, kann aus der gemessenen Ruhespannung auf den Ladezustand geschlossen werden. Da bei dieser Prüfung kaum Strom fliesst und daher keine chemische Reaktion abläuft, ist diese Prüfung relativ unempfindlich hinsichtlich der Temperatur des Akkumulators. Voraussetzung für eine zuverlässige Prüfung ist jedoch, dass eine echte Ruhespannung anliegt. Anderenfalls wird nach dem Laden ein zu hoher bzw. nach dem Entladen ein zu niedriger Spannungswert gemessen. Da der Akkumulator während des Fahrbetriebes durch den Generator ständig geladen oder durch eingeschaltete Verbraucher mehr oder weniger entladen wird, muss für eine zuverlässige Ladezustandsprüfung eine Ruhezeit von mindestens 12 Stunden abgewartet werden. Diese lange Wartezeit ist in der Praxis sehr hinderlich.

Ein zweites herkömmliches Verfahren prüft den Spannungsabfall an den Batteriepolen unter Last. Bei einer Prüfung mit einem hohen Prüfstrom wird der Spannungsabfall durch die einsetzende, chemische Reaktion abgefangen, deren Ablauf aber eher von dem Erhaltungszustand als von dem Ladezustand der Batterie bestimmt wird (siehe z.B. DE-A-31 08 844). Auch ist die Reaktionsgeschwindigkeit sehr temperaturabhängig. Bei gleichem Ladezustand des Akkumulators ist der Spannungsabfall unter Last bei niedrigen Temperaturen erheblich grösser als bei höheren. Im normalen Fahrbetrieb ist die Starterbatterie aber ständig wechselnden Temperaturen ausgesetzt, so dass nicht nur die Berücksichtigung des Erhaltungszustands, sondern auch eine Temperierung der Batterie bei einer solchen Prüfung notwendig wäre. Da ein autonomes Prüfgerät kaum die gleiche Temperatur wie die Batterie hätte, wäre eine Temperaturkompensation im Prüfgerät kaum wirksam.

Weiterhin sind relativ aufwendige Verfahren bekannt, die auf Messungen des Batteriestromes beruhen. In der DE-A-31 30 669 z.B. werden Lade- und Entlade-Ströme vorzeichenrichtig summiert und elektronisch gespeichert. In der DE-A-30 31 852 werden Strommessungen - wegen des Obengesagten unter Zuhilfenahme von Messungen der Elektroylttemperatur - herangezogen, um Spannungsmessungen zu korrigieren. Diese Verfahren setzen eine ständige Verbindung des Prüfgeräts mit der zu prüfenden Batterie voraus und sind somit für ein autonomes Prüfgerät ungeeignet.

Aufgabe der Erfindung ist es, ein Verfahren und eine einfache, autonome Vorrichtung bereitzustellen, die den Ladezustand der Starterbatterie unabhängig vom Zeitpunkt der Prüfung richtig anzeigt.

Die Aufgabe wird erfindungsgemäss mit dem im Patentanspruch 1 angegebenen Verfahren bzw. der im Anspruch 2 oder 3 angegebenen Vorrichtung gelöst.

Die Werte von $U_1$, $U_R$ und $T_R - T_1$, mit denen die Korrektur der gemessenen Leerlaufspannung $U_2$ berechnet wird, können an einem gegebenen Batterieladegerät oder Fahrzeug-Generator bzw. an einer gegebenen Starterbatterie gemessen werden. Man kann aber ebenso gut Standardwerte verwenden, wie sie z.B. Handbüchern über Batterien, Ladegeräte und KFZ-Elektrik zu entnehmen sind. Bei einem Bleiakkumulator ist $U_1$ etwa 2,3 Volt und $U_R$ etwa 2,1 Volt pro Zelle, bei einem 12 Volt-Akkumulator also etwa $U_1 = 14$ Volt und $U_R = 12,7$ bis 12,8 Volt. Für $T_R - T_1$ können 12 Stunden angenommen werden.

In dem erfindungsgemässen Verfahren wird der Spannungsverlauf am Akkumulator nach dem Abschalten des Generators bis hin zur Ruhespannung berücksichtigt und so korrigiert, dass zu jedem Zeitpunkt nicht der zeitliche Spannungswert, sondern der Ladezustand angezeigt wird.

Abhängig vom Ladezustand ergeben sich nach Stillstand des Generators unterschiedliche Spannungsverläufe an den Polen der Starterbatterie. Im normalen Fahrbetrieb wird der Akkumulator aufgrund der höheren Generatorspannung ständig geladen. Nach Stillstand des Fahrzeugs bzw. des Generators bleibt ein erhöhter Spannungswert als sogenannte Überspannung oder Polarisationsspannung über einen längeren Zeitraum messbar erhalten. Ist der Akkumulator unbelastet und voll geladen, baut sich diese Überspannung nur langsam, über einen Zeitraum von etwa 12 Stunden, bis zur eigentlichen Ruhespannung ab. Bei einem Akkumulator, der mehr oder weniger entladen ist, wird - wegen des steileren elektrochemischen Gradients - diese Überspannung entsprechend schneller abgebaut.

Nach Beendigung des Ladevorgangs kommt es deshalb zu unterschiedlichen Spannungsverläufen, bei denen die Überspannung in Abhängigkeit des Ladezustands und der seit dem Ladevorgang verflossenen Zeit mehr oder weniger schnell bis zur Ruhespannung abfällt. Während dieser Zeit kann nicht zuverlässig aus der

EP 0 508 030 B1

gemessenen Spannung auf den Ladezustand geschlossen werden.

Ausgehend von dem Normalfall, d.h. dem langsamen Überspannungsabbau am vollgeladenen Akkumulator, wird in dem erfindungsgemässen Verfahren eine zeitabhängige Korrektur der gemessenen Polspannung vorgenommen. Dadurch wird erreicht, dass der Ladezustand zu jedem Zeitpunkt nach Stillstand des Generators richtig angezeigt wird. Bei der Anpassung wird entweder die Ladezustandsskala gegenüber der Spannungsanzeige um den Betrag der Korrektur verschoben, oder es werden die gemessen Spannungswerte um den Betrag der Korrektur so verändert, dass nicht die Polspannung, sondern eine dem Ladezustand entsprechende Spannung angezeigt wird.

Die erfindungsgemässe Korrektur sei an einem Beispiel erläutert: In einem Fahrzeug, das zu einem Zeitpunkt $T_1$ abgestellt wird, befindet sich eine übliche Starterbatterie mit einer Nennspannung von 12 Volt. Die Anzahl Zellen $n_z$ in dieser Batterie ist 6. Bis zum Abstellen des Fahrzeugs wurde die Batterie vorschriftsmässig mit einer Generator-Spannung $U_1$ von etwa 14 Volt geladen. Zu einem Zeitpunkt $T_R$, nach einer Ruhezeit $T_R$ - $T_1$ von etwa 720 Minuten, stellt sich eine Ruhespannung $U_R$ von 12,8 Volt an den Polen einer vollgeladenen Batterie dieses Typs ein. Zu einem beliebigen zwischen $T_1$ und $T_R$ liegenden Zeitpunkt $T_2$ wird die Polspannung $U_2$ gemessen. Mit der Prüfspannung $U_2$ ist für diese Batterie die korrigierte Spannung $U_K$ zu errechnen mit:

$$U_K = U_2 - 0{,}15 \cdot [U_1 - U_R] \cdot [\ln(T_R - T_1) - \ln(T_2 - T_1)] \quad (\text{Volt}) \qquad [1]$$

$$= U_2 - 0{,}15 \cdot [14 - 12{,}8] \cdot [\ln(720 - T_1) - \ln(T_2 - T_1)]$$

$$= U_2 - 0{,}18 \cdot [\ln(720 - T_1) - \ln(T_2 - T_1)]$$

Aus dem korrigierten Spannungswert $U_K$ lässt sich die Dichte des Elektrolyts $D_E$ annähernd errechnen mit der bekannten Gleichung:

$$D_E = U_K / n_Z - 0{,}84 \ (\text{g/ml}). \quad [2]$$

Aufgrund der so errechneten Elektrolytdichte, kann der Ladezustand der Batterie entweder begrifflich (z.B. mit "geladen", "halbgeladen", "entladen") oder in Prozent oder mit den gebräuchlichen Farben (Grün, Gelb, Rot) des handelsüblichen Säureprüfers bezeichnet werden, denn eine Masseinheit für den Ladezustand gibt es nicht.

Die Vorrichtung zur Durchführung des erfindungsgemässen Verfahrens beinhaltet ein bekanntes, elektromechanisches oder elektronisches Spannungsmesswerk, bei dem die gemessene Polspannung in eine entsprechende Ladezustandsanzeige umzuwandeln ist. Das Spannungsmesswerk kann z.B. ein Drehspulmessinstrument sein, dessen Skala in Abhängigkeit des korrigierten Spannungswertes den Ladezustand z.B. in Form der bekannten Farbsektoren GRÜN, GELB, ROT und/oder in Prozent der Gesamtladungsmenge anzeigt. Ein elektronisches Spannungsmesswerk lässt sich z.B. aus Komparatoren aufbauen, an deren Eingängen die Akkumulatorspannung mit einer Referenzspannung verglichen und an deren Ausgängen eine Kette aus optischen Anzeigeelementen entsprechend aktiviert wird. Durch die Verwendung von z.B. farbigen Leuchtdioden als Anzeigeelemente können die jeweiligen Ladezustände unverwechselbar dargestellt werden. Gleichfarbige Anzeigeelemente können mit durchsichtigen Farbsegmenten überdeckt sein, so dass der Ladezustand als GRÜN, GELB oder ROT angezeigt wird. Die einfache Farbanzeige kann durch Angabe der prozentualen Ladungsmenge ersetzt bzw. ergänzt werden.

Die erfindungsgemässe Korrektur der gemessen Polspannungen kann z.B. in der Form geschehen, dass der Messwerksausschlag an einer in Abhängigkeit der nach Beendigung des Ladevorgangs verflossenen Zeit verstellbaren Ladezustands-Skala abgelesen wird. Für ein Drehspulinstrument bedeutet dies, dass dessen Ladezustands-Skala in Beziehung zu einer Zeitskala verstellbar angeordnet sein muss. Bei Verwendung einer Kette aus optischen Anzeigeelementen können die Ladezustandssektoren in einem in Richtung der Anzeigeänderungen verstellbaren Schieber angeordnet sein.

Umgekehrt kann die Ladezustands-Skala unverstellbar sein, während die am Akkumulator gemessenen Spannungswerte z.B. durch einen dem Eingang des Messwerks vorgeschalteten Spannungsteiler aus Fest- und Drehwiderständen korrigiert werden. Dabei reduziert der über eine Zeitskala verstellbare Drehwiderstand den gemessenen Spannungswert kontinuierlich in Abhängikeit der verflossenen Zeit. Sollen Messungen nur zu bestimmten Zeiten durchgeführt werden, kann der Drehwiderstand durch entsprechend bemessene Festwiderstände ersetzt werden.

Das erfindungsgemässe Verfahren mit Beispielen geeigneter Vorrichtungen wird in den nachstehenden Figuren näher erläutert. Dabei zeigen:

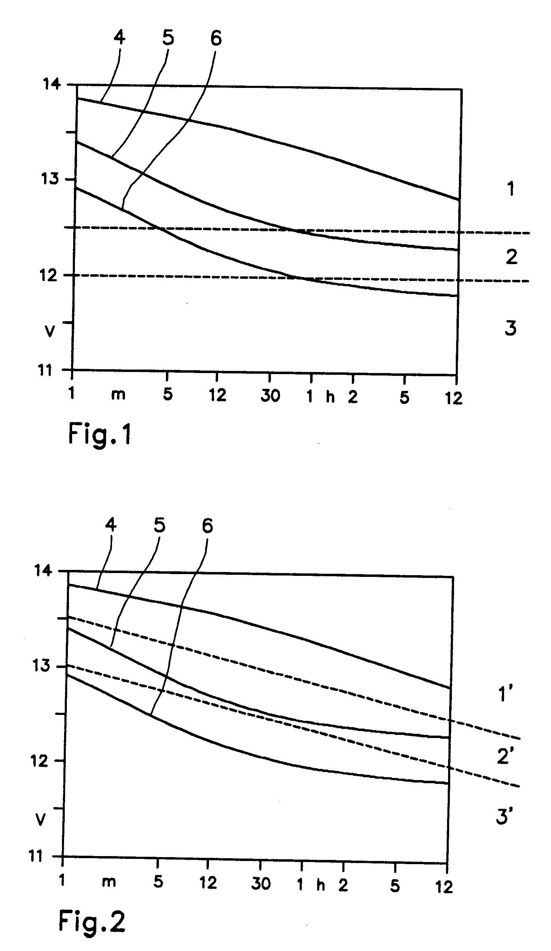

Fig. 1       Spannungskurven von drei Akkumulatoren mit unterschiedlichem Ladezustand im Vergleich zu einer unkorrigierten Ladezustandsanzeige, entsprechend dem Stand der Technik,

| Fig. 2 | die Spannungskurven gemäss Figur 1 im Vergleich zu einer korrigierten Ladezustandsanzeige, |
| Fig. 3a | eine mechanische Ausführungsform des zeitabhängigen Korrekturmittels in einer ersten Stellung, |
| Fig. 3b | die Ausführungsform von Figur 3a in einer anderen Stellung, |
| Fig. 3c | die Spannungskurven von Figur 2 mit Bezug zu dem Korrekturmittel der Figuren 3a und 3b, |
| Fig. 4 | eine Spannungskorrektur bei unveränderlicher Ladezustands-Skala, |
| Fig. 5a und 5b | eine elektrische Ausführungsform eines zeitabhängigen Korrekturmittels, |
| Fig. 6 | eine modifizierte Ausführung des Korrekturmittels gemäss Figur 5a und |
| Fig. 7 und 8 | eine bevorzugte Ausführungsform der Prüfvorrichtung. |

Das Diagramm in Figur 1 zeigt die Spannungsverläufe eines unbelasteten Akkumulators mit drei unterschiedlichen Ladezuständen. Auf der linear geteilten Senkrechten sind die Spannungswerte am Akkumulator (11 bis 14 Volt) und auf der logarithmisch geteilten Waagerechten die seit Beendigung des Ladevorgangs verflossene Zeit (1 bis 30 Minuten und 1 bis 12 Stunden) eingetragen. Die Kurve 4 zeigt den charakteristischen Spannungsverlauf eines voll geladenen Akkumulators. Etwa eine Minute nach Beendigung des Ladevorgangs bzw. nach Abschalten des Generators beträgt die Polspannung etwa 13,8 V und baut sich dann über einen Zeitraum von etwa 12 Stunden bis zur Ruhespannung von etwa 12,8 V langsam ab. Danach bleibt die Spannung - abgesehen von der dann einsetzenden Selbstentladung - nahezu konstant. Ist der Akkumulator teilentladen, so ist die Polspannung anfangs niedriger und baut sich deutlich schneller ab. So zeigt die Kurve 5 die Spannungsänderung an einem halbentladenen Akkumulator und die Kurve 6 die Spannungsänderung an einem entladenen Akkumulator. Neben den Spannungskurven sind drei Sektoren einer herkömmlichen Ladezustandsanzeige mit unterbrochenen Linien dargestellt. Dabei entspricht Sektor 1 "geladen", Sektor 2 "halbgeladen" und Sektor 3 "entladen". Wird unmittelbar nach Beendigung des Ladevorgangs eine Prüfung vorgenommen, so wird der Ladezustand aller drei Akkumulatoren als "geladen" angezeigt, da die Spannungswerte der Kurven 4, 5 und 6 alle im Sektor 1 liegen. Es kann somit zu diesem Zeitpunkt keine zuverlässige Aussage über den Ladezustand gemacht werden. Erst nach ca. einer Stunde wechselt die Polspannung des halbentladenen Akkumulators (Kurve 5) von Sektor 1 nach Sektor 2, wodurch die Anzeige von "geladen" nach "halbgeladen" wechselt. Der entladene Akkumulator (Kurve 6) wird zunächst als "geladen", nach ca. 5 Minuten als "halbgeladen" (Sektor 2) und erst nach etwa einer Stunde als "entladen" (Sektor 3) angezeigt. Um eine zuverlässige Anzeige zu erhalten, muss demnach erst eine längere Ruhezeit vor der Prüfung vergangen sein.

Das Diagramm Figur 2 zeigt ebenfalls die Spannungskurven 4, 5 und 6 gemäss Figur 1. Die Ladezustandssektoren 1', 2' und 3' sind jetzt aber erfindungsgemäss dem zeitlichen Verlauf der Spannungskurve 4 eines geladenen Akkumulators so angepasst, dass die Spannungskurve 4 und die drei Anzeigesektoren annähernd parallel verlaufen. Jetzt wird zu jedem Zeitpunkt nach Beendigung des Ladevorgangs der tatsächliche Ladezustand des geprüften Akkumulators richtig angezeigt. Die Spannungswerte der Kurve 4 verbleiben während der gesamten Ruhezeit von einer Minute bis 12 Stunden im Sektor 1' = "geladen", die Spannungswerte der Kurve 5 im Sektor 2' = "halbgeladen" und die Spannungswerte der Kurve 6 im Sektor 3' = "entladen".

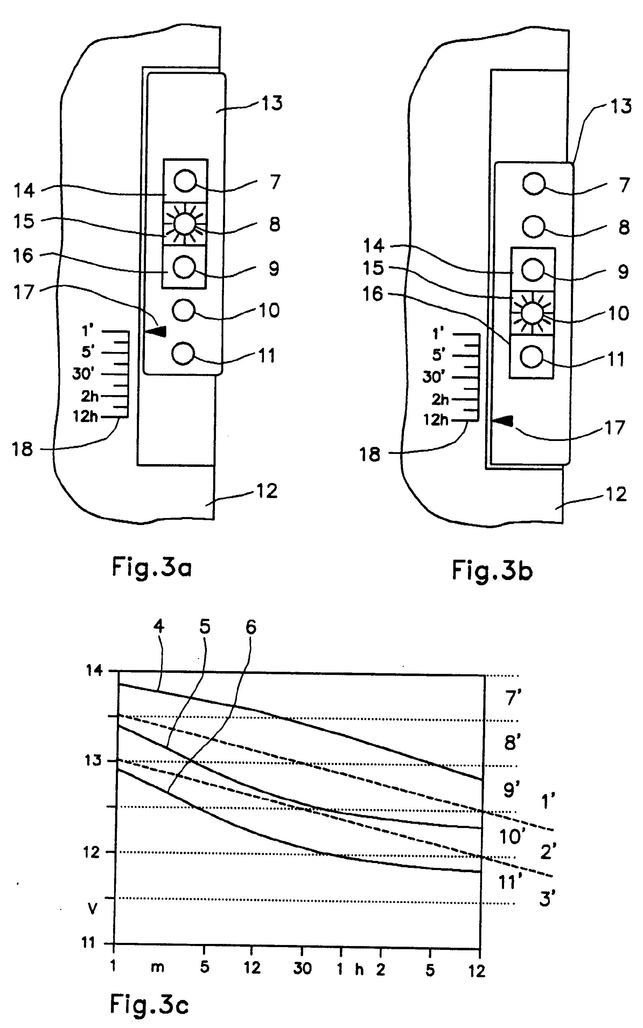

Die Figuren 3a und 3b zeigen ein mechanisches Mittel zur erfindungsgemässen Korrektur der Ladezustandsanzeige. Ein Gehäuse 12 enthält einen Spannungsmesser, dessen Anzeige aus einer Kette gleichfarbiger, optischer Anzeigeelemente z.B. in Form von fünf Leuchtdioden 7 bis 11 besteht. Dass fünf Anzeigeelemente benötigt werden, obwohl nur drei Ladezustandsbereiche angezeigt werden sollen, ergibt sich aus der Figur 3c, die wiederum die Polspannungskurven von Figur 2 zeigt. Zusätzlich sind mit punktierten Linien die fünf Spannungsbereiche 7' bis 11' der Anzeigeelemente 7 bis 11 veranschaulicht. Diese müssen den gesamten Bereich der möglichen Akkumulator-Polspannungen umfassen, jedoch mit einer höheren Auflösung als die herkömmliche Ladezustandsanzeige von Figur 1. Erfindungsgemäss sind die zeitlichen Änderungen dieser Spannungen zu berücksichtigen, was faktisch eine Erhöhung der Anzeigegenauigkeit bedeutet.

Über den Anzeigeelementen 7 bis 11 ist die Ladezustandsskala in Form eines in Richtung der Leuchtdioden-Kette verstellbaren Schiebers 13 angebracht. In dem Schieber 13 befinden sich die farbigen, durchsichtigen Segmente 14, 15, 16, z.B. aus Kunststoff oder Glas, die den Ladezustands-Sektoren 1', 2', 3' von Figur 3c entsprechen. So entspricht Segment 14 dem Ladezustand "geladen", Segment 15 dem Ladezustand "halbgeladen" und Segment 16 dem Ladezustand "entladen". Bei der Verwendung von z.B. gelben Leuchtdioden und durchsichtigen grünen, gelben bzw. roten Segmenten ist gewährleistet, dass beim Aufleuchten der darunterliegenden Diode der Ladezustand farblich eindeutig angezeigt wird. Auf dem Gehäuse 12 ist gegenüber einer auf dem Schieber 13 befindlichen Einstellmarke 17 die etwa logarithmisch geteilte Zeitskala 18 angebracht, die den Verstellbereich des Schiebers entsprechend etwa einer Minute bis 12 Stunden Ruhezeit markiert.

In Figur 3a ist der Schieber 13 mittels Einstellmarke 17 auf die Marke "1 min." der Zeitskala 18 eingestellt, was einer Spannungsprüfung ca. eine Minute nach Abschalten des Generators entspricht. Bei einem halbgeladenen Akkumulator (Spannungskurve 5 von Figur 3c) befindet sich die Polspannung im Spannungsbereich 8' des Anzeigeelements 8. Es leuchtet die Leuchtdiode 8 unter dem Segment 15 von Figur 3a und zeigt somit den halbgeladenen Zustand des Akkumulators an.

In Figur 3b ist der Schieber 13 mittels Einstellmarke 17 auf die Marke "12h" der Zeitskala 18 gestellt, was einer Messung ca. 12 Stunden nach Abschalten des Generators entspricht. Da die Polspannung zwischenzeitlich gefallen ist, liegt die Spannungskurve 5 von Figur 3c jetzt im Spannungsbereich 10' des Anzeigeelements 10. Somit leuchtet nun die niedrigere Leuchtdiode 10 von Figur 3b. Da aber gleichzeitig der Schieber 13 entsprechend der verflossenen Zeit neu eingestellt wurde, ist auch jetzt Segment 15 beleuchtet, wodurch der Akkumulator auch zu diesem Zeitpunkt als "halbgeladen" angezeigt wird. Auch zu dazwischenliegenden Prüfungszeitpunkten wird der Zustand "halbgeladen" angezeigt, da die Ladezustandsskala entsprechend der Zeitskala 18 dem zeitlichen Abfall der Polspannung nachgeführt wird.

Für eine hinreichend genaue, dreistufige Anzeige gemäss Figur 3a und b sind demnach fünf Anzeigeelemente erforderlich, sofern Messungen im gesamten Zeitbereich durchführbar sein sollen. Für die Anzeige von mehr als drei Ladezuständen wären noch mehr Anzeigeelemente erforderlich. Wenn hingegen nicht die Ladezustands-Skala sondern die angezeigte Spannung selbst korrigiert wird, wird dieser Nachteil vermieden.

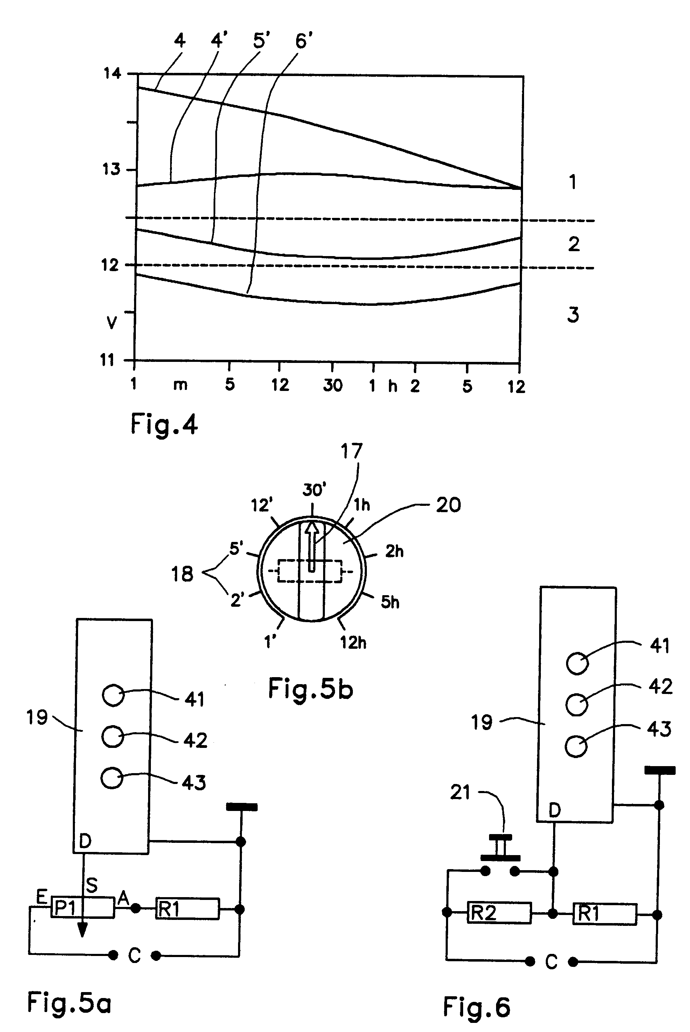

Das Diagramm Figur 4 zeigt, wie z.B. die Spannungskurve 4 gemäss Figur 1 und 2 in Abhängigkeit der Zeit durch geeignete elektrische Korrekturmittel in die Kurve 4' so geändert werden kann, dass die angezeigte Spannung über den gesamten Zeitraum einen annähernd konstanten Wert annimmt. Dieser Änderung entsprechend werden die Kurven 5 und 6 gemäss den Figuren 1 und 2 in die Kurven 5' und 6' von Figur 4 gewandelt. In diesem Falle können die Spannungsbereiche gleichzeitig die Ladezustandssektoren sein. Das Prüfgerät gibt auch jetzt zu jedem Messzeitpunkt eine gleichbleibende Anzeige aus, da die angezeigten Spannungswerte ihren jeweiligen Ladezustandssektor 1,2 oder 3 nicht wechseln. Die Obergrenze der angezeigten Spannung wird dadurch von 14 auf etwa 13 Volt verkleinert, so dass die Anzahl der Anzeigeelemente gleich der Anzahl der Ladezustandssektoren ist.

Figuren 5a und 5b zeigen ein elektrisches Mittel zur Korrektur der gemessenen Spannung gemäss Figur 4. Einem bekannten Spannungsmesswerk 19 mit dreistufiger Leuchtdioden-Anzeige 41, 42, 43, entsprechend den drei Ladezustandssektoren 1, 2, 3 von Figur 4, ist ein Spannungsteiler bestehend aus dem Festwiderstand R1 und dem Drehwiderstand P1 vorgeschaltet. Die Akkumulatorspannung liegt am Eingang C der Schaltung an. Der Schleifer S des Drehwiderstands P1 ist auf den Eingang D des Messwerks 19 geführt. In dieser Anordnung bewirkt ein Verstellen des Drehwiderstandes P1 eine Änderung der Akkumulatorspannung am Eingang D des Messwerks. Liegt der Schleifer S des Drehwiderstandes P1 an E, so wird die unkorrigierte Akkumulatorspannung an den Eingang D des Messwerks 19 gelegt, was einer Ruhespannungsmessung nach 12 Stunden oder länger entspricht. Durch Bewegen des Schleifers S in Richtung A wird die am Eingang C liegende Akkumulatorspannung so korrigiert, dass der Spannungsabfall zwischen E und S der jeweiligen Spannungsdifferenz zwischen der zeitlichen Überspannung und der Ruhespannung entspricht.

Zur zeitabhängigen Korrektur der gemessenen Spannung ist die Drehachse des Drehwiderstandes P1, wie in Figur 5b gezeigt, mit einem Drehknopf 20 versehen. Dieser trägt die Pfeilmarkierung 17, die gegenüber einer z.B. auf einem Gehäuse befindlichen, etwa logarithmisch geteilten Zeitskala 18 einstellbar ist. Ebensogut könnte die Zeitskala 18 auf dem Drehknopf und die Pfeilmarkierung 17 auf dem Gehäuse angebracht sein. Bei der Prüfung wird der Drehkopf 20 so gestellt, dass die Pfeilmarkierung 17 die verflossene Ruhezeit auf der Zeitskala 18 anzeigt. Die gemäss Figur 4 korrigierte Spannung, die nunmehr dem Ladezustand entspricht, wird durch eine der Leuchtdioden 41, 42, 43 des Messwerks 19 angezeigt.

Anstatt der Spannungsmessung zu jeder beliebigen Zeit können Messungen zu bestimmten Zeitpunkten für eine Akkumulatorprüfung ggf. zweckkmässig sein. Dazu kann der Drehwiderstand P1 durch einen oder mehrere Festwiderstände ersetzt werden, wobei jedem Festwiderstand ein Schaltelement, z.B. in Form eines Tasters, parallel geschaltet ist. Die Anzahl der Kombinationen aus Festwiderstand und Schaltelement bestimmt dabei die Anzahl der möglichen Prüfungszeitpunkte.

Insbesondere in der Praxis des Heimwerkers könnte man davon ausgehen, dass der Akkumulator meist entweder unmittelbar nach Fahrbetrieb oder nach einer mehrstündigen Ruhezeit, z.B. vor dem morgendlichen Anlassen des Motors, geprüft würde. In einem solchen Falle würde die Beschränkung der Prüfung auf diese beiden Zeitpunkte das Wissen um die verflossene Ruhezeit entbehrlich machen und die Bedienung des Prüfgeräts insoweit vereinfachen. Die Figur 6 zeigt eine derart vereinfachte Ausführungsform der erfindungsgemässen Vorrichtung. Hier ist der Drehwiderstand von Figur 5a und 5b beispielsweise durch einen Festwiderstand R2 und einen parallel geschalteten Taster 21 ersetzt. Durch das Kurzschliessen des Festwiderstands mittels Taster 21 ändert sich das Widerstandsverhältnis im Spannungsteiler und somit die Spannung am Eingang D des Messwerks 19. Bei geöffnetem Taster 21 wird die Akkumulatorspannung entsprechend dem Widerstandsverhältnis von R1 zu R2 geändert, bei geschlossenem Taster hingegen unverändert auf den Eingang D des Messwerks 19 gelegt. Hierbei wird der Widerstand R2 gegenüber R1 so bemessen, dass der Spannungsabfall genau der Spannungsdifferenz zwischen der Überspannung beim Abschalten des Generators und der Ruhespannung, d.h. der Zeitkorrektur für eine Prüfung nach einer Minute, entspricht.

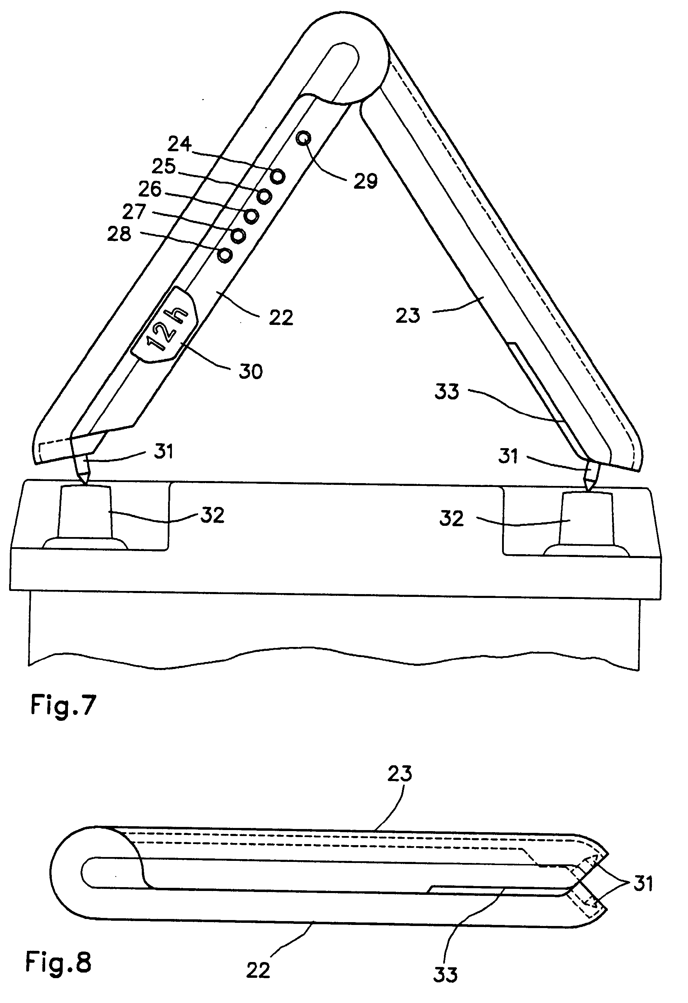

Figur 7 zeigt eine bevorzugte Ausführungsform der erfindungsgemässen Prüfvorrichtung, z.B. mit elektrischer, zeitabhängiger Anzeigekorrektur, während des Prüfvorganges. Die Vorrichtung besteht aus zwei gelenkig miteinander verbundenen Schenkeln 22, 23, wobei der Schenkel 22 in Form eines länglichen Hohlkörpers ausgebildet ist. Schenkel 23 ist eine Halbschale mit etwa u-förmigem Querschnitt, dessen offene Längsseite dem Schenkel 22 zugewandt ist. In dem Schenkel 22 ist z.B. das Messwerk und die Korrekturschaltung analog zu Figur 6 angeordnet. Für eine genauere Akkumulatorprüfung wird anstelle der dreistufigen Ladezustands-Anzeige von Figur 6 eine fünfstufige Ladezustands-Anzeige, die beispielsweise aus zwei grünen 24, 25, zwei gelben 26, 27 und einer roten Leuchtdiode 28 bestehen kann, verwendet. Dabei entspricht die Farbe Grün dem Ladezustand "geladen", Gelb dem Ladezustand "halbgeladen" und Rot dem Ladezustand "entladen". Weil es jeweils zwei grüne und gelbe Leuchtdioden gibt, lässt sich der Ladezustand genauer beurteilen. Der Taster 21 der Korrekturschaltung von Figur 6 ist über einen in den Schenkel 22 integrierten Tastknopf 30 bedienbar, der die Aufschrift "12h" trägt. Die Kontaktspitzen 31 sind mit dem Eingang C der Korrekturschaltung gemäss Figur 6 verdrahtet und stellen so die elektrische Verbindung zu den Akkumulatorpolen 32 her. Neben der fünfstufigen Ladezustands-Anzeige ist eine zusätzliche Leuchtdiode 29 für einen Generatortest vorgesehen.

Für eine Prüfung sogleich nach dem Abstellen der Fahrzeuges, d.h. innerhalb etwa einer Minute nach Abschalten des Generators, wird der Tastknopf 30 nicht gedrückt. Das Prüfgerät wird mit den Kontaktspitzen 31 auf die Akkumulatorpole 32 aufgesetzt und der Ladezustand kann direkt auf der fünfstufigen Leuchtdioden-Anzeige 24 bis 28 abgelesen werden. Bei einer Ruhespannungsmessung nach ca. 12 Stunden oder länger wird der Tastknopf 30 gemäss dem aufgedruckten Hinweis "12h" gedrückt und der Ladezustand wie vor abgelesen. Wird der Akkumulator als mehr oder weniger entladen angezeigt, so ist es sinnvoll, einen Generatortest bei laufendem Motor durchzuführen, wobei der Tastknopf 30 ebenfalls nicht betätigt wird. Mittels der fünfstufigen Anzeige 24 bis 28 und der Leuchtdiode 29, die bei zu hoher Generatorspannung aufleuchtet, wird die Ladespannung geprüft. Um die Handhabung zu erleichtern, kann die Prüfvorrichtung mit einem Verpolungsschutz, z.B. durch Vorschalten eines bekannten Brückengleichrichters, ausgestattet sein, so dass auf die Batteriepolung nicht geachtet werden muss.

In Figur 8 ist die Prüfvorrichtung von Figur 7 im geschlossenen Zustand dargestellt. Dabei sind die im Schenkel 22 befindlichen Bedienungs- und Anzeigeelemente durch den schalenförmigen Schenkel 23 verdeckt und vor Beschädigung und Verschmutzung geschützt. Die Kontaktspitzen 31 sind derart in unterschiedlichen Schwenkebenen angeordnet, dass sie nebeneinanderliegend von den übergreifenden Enden des jeweils anderen Schenkels verdeckt sind. Die Aussparung 33 dient als Griffleiste, die das Öffnen der Prüfvorrichtung erleichtert.

Anstelle der Korrekturschaltung von Figur 6 könnte ebensogut die Schaltung von Figur 5a hier verwendet werden. Hierzu würde man z.B. den Drehknopf 20 von Figur 5b durch ein vom Schenkel 23 abdeckbares Stellrad mit entsprechender Zeitskala 18 ersetzen. Ebenfalls wäre es möglich, ein mechanisches Korrekturmittel analog zu Figur 3a und 3b in der bevorzugten Ausführungsform der Figuren 7 und 8 zu verwenden.

## Patentansprüche

1. Verfahren zur Prüfung des Ladezustands eines elektrischen Akkumulators, insbesondere einer Starterbatterie, an deren Polen bis zu einem Zeitpunkt $T_1$ eine Ladespannung $U_1$ anliegt und die nach Beendigung des Ladens beim Erreichen des elektrochemischen Gleichgewichtes zu einem späteren Zeitpunkt $T_R$ eine Ruhe-Leerlaufspannung aufweist, welche bei vollgeladener Batterie einen Wert $U_R$ hat, dadurch gekennzeichnet, dass in einem Zeitpunkt $T_2$, der nach dem Zeitpunkt $T_1$ und vor dem Zeitpunkt $T_R$ liegt, die Leerlauf-Spannung $U_2$ der unbelasteten Batterie gemessen und in eine dem Ladezustand der Batterie entsprechende Anzeige dadurch gewandelt wird, dass von der gemessenen Spannung $U_2$ ein Betrag entsprechend mindestens 5% und höchstens 25% des Betrages $U_1 - U_R$, multipliziert mit dem natürlichen Logarithmus des Quotienten aus der Zeitspanne $T_R - T_1$ dividiert durch die Zeitspanne $T_2 - T_1$, subtrahiert wird.

2. Vorrichtung zur Durchführung des Verfahrens nach Anspruch 1, mit einem elektromechanischen oder elektronischen Spannungs-Messwerk mit Spannungsanzeige (7 bis 11) und einer Ladezustands-Skala (13 bis 16), dadurch gekennzeichnet, dass die Ladezustands-Skala (13 bis 16) in Beziehung zu einer etwa logarithmischen Zeitskala (18) unabhängig von der Spannungs-Anzeige (7 bis 11) verstellbar ist.

**3.** Vorrichtung zur Durchführung des Verfahrens nach Anspruch 1, mit einem elektromechanischen oder elektronischen Spannungs-Messwerk mit Spannungsanzeige (41 bis 43) und einer Ladezustands-Skala (41 bis 43), dadurch gekennzeichnet, dass die angezeigte Spannung in Beziehung zu einer etwa logarithmischen Zeitskala (18) unabhängig von der gemessenen Spannung veränderbar ist.

**4.** Vorrichtung nach Anspruch 2 oder 3, dadurch gekennzeichnet, dass ein Gehäuse aus zwei gelenkig verbundenen Schenkeln (22, 23) besteht, die derart zusammenpassen, dass sie beim Schliessen des Gelenks einen einzigen, äusserlich geschlossenen Körper bilden, wobei der eine Schenkel (22) als länglicher Hohlkörper zur Aufnahme des Spannungs-Messwerks und -Anzeigeelemente sowie der Skalen und Korrekturmittel ausgebildet ist, während der andere Schenkel (23) als offenes Profil oder Halbschale ausgebildet ist, und dass die Schenkel so geformt sind, dass die Anzeigeelemente, Skalen und Korrekturmittel des einen Schenkels (22) bei geöffnetem Gelenk zur Beobachtung und Bedienung freiliegen und beim Schliessen des Gelenks durch den anderen Schenkel (23) verdeckt und geschützt werden, und dass beide Schenkel an ihren vom Gelenk abgelegenen Enden Kontaktspitzen (31) aufweisen, die mit dem Messwerk elektrisch leitend verbunden sind und räumlich in verschiedenen Schwenkebenen liegen, so dass sie beim Schliessen des Gelenks, nebeneinander liegend, von dem offenen Ende des jeweils anderen Schenkels ganz oder teilweise verdeckt sind.

## Claims

**1.** A method for testing the state of charge of an electric accumulator, in particular an automobile battery, which has been charged with a charging voltage $V_1$ up to a point of time $T_1$, and which, thereafter being quiescent and reaching electrochemical equilibrium at a later point of time $T_E$, has attained an equilibrium open circuit voltage which, for a fully charged battery, has a value $V_E$, characterised in that at a point of time $T_2$ later than the point of time $T_1$ and earlier than the point of time TE the open circuit voltage $V_2$ of said battery is measured and converted into a reading indicative of the state of battery charge by subtracting from said voltage $V_2$ an amount corresponding to at least 5 % and at most 25 % of the amount $V_1 - V_E$ multiplied by the natural logarithm of the quotient obtained by dividing the time span $T_E - T_1$ by the time span $T_2 - T_1$.

**2.** An apparatus for carrying out the method according to claim 1, comprising an electromechanical or electronic voltmeter with a voltage indicator means (7 to 11) and a state-of-charge scale (13 to 16), characterised in that the state-of-charge scale (13 to 16) is adjustable, independently of said voltage indicator means (7 to 11), in relation to an approximately logarithmic time scale (18).

**3.** An apparatus for carrying out the method according to claim 1, comprising an electromechanical or electronic voltmeter with a voltage indicator means (41 to 43) and a state-of-charge scale (41 to 43), characterised in that the indicated voltage is adjustable, independently of the measured voltage, in relation to an approximately logarithmic time scale (18).

**4.** An apparatus in accordance with claim 2 or 3, characterised in that a case consists of two pivoted legs (22, 23) which fit together in such a manner that in a closed position they form a single, externally closed body, the one leg (22) being an elongated hollow body which contains the voltmeter with the indicator means and the scales and correction means, the other leg (23) being an open profile or half-shell, and in that said legs are so formed that the indicator means, scales and correction means of said one leg (22) are exposed for actuation and observation when said legs are pivoted to an open position, and are covered and protected by said other leg (23) when said legs are pivoted to a closed position, and in that at their ends opposite the pivot both of said legs are fitted with contact points (31) which are electrically connected with the voltmeter and which lie in different pivotal planes, so that in the closed position they are located side by side, each being partly or completely covered by the open end of the other of said legs.

## Revendications

**1.** Procédé de contrôle de l'état de charge d'un accumulateur électrique, en particulier d'une batterie de démarrage, aux pôles duquel s'applique jusqu'à un instant $T_1$ une tension de charge $U_1$ et qui, après avoir été chargé, lorsqu'est atteint l'équilibre électrochimique, présente, à un instant $T_R$ ultérieur, une tension de marche à vide de repos, qui lorsque la batterie est totalement chargée a une valeur $U_R$, caractérisé en ce qu'à un instant $T_2$, qui se situe après l'instant $T_1$ et avant l'instant $T_R$, la tension de marche à vide $U_2$ de la batterie non chargée est mesurée et est convertie en une indication correspondant à l'état de charge de la batterie, en ce que de la tension mesurée $U_2$ il est soustrait une valeur correspondant au moins à 5 % et au plus à 25 % de la valeur $U_1 - U_R$, multipliée par le logarithme naturel du quotient de l'intervalle de temps $T_R - T_1$ divisé par l'intervalle de temps $T_2 - T_1$.

2. Dispositif pour la mise en oeuvre du procédé selon la revendication 1, comportant un appareil de mesure de tension électromécanique ou électronique avec affichage de la tension (7 à 11) et une échelle d'état de charge (13 à 16), caractérisé en ce que l'échelle d'état de charge (13 à 16) peut être réglée par rapport à une échelle de temps (18) logarithmique, indépendamment de l'affichage de la tension (7 à 11).

3. Dispositif pour la mise en oeuvre du procédé selon la revendication 1, comportant un appareil de mesure de tension électromécanique ou électronique avec affichage de la tension (41 à 43) et une échelle d'état de charge (41 à 43), caractérisé en ce que la tension affichée peut être modifiée par rapport à une échelle de temps (18) logarithmique, indépendamment de la tension mesurée.

4. Dispositif selon les revendications 2 ou 3, caractérisé en ce qu'un boîtier est constitué de deux côtés (22, 23), reliés articulés, qui s'ajustent l'un à l'autre de manière à former, lors de la fermeture de l'articulation, un corps unique, extérieurement fermé, un côté (22) se présentant sous la forme d'un corps creux allongé destiné à recevoir l'appareil de mesure de tension et des éléments d'affichage de tension ainsi que les échelles et les moyens de correction, tandis que l'autre côté (23) est un profilé ouvert ou une demi-coque, et en ce que les côtés sont formés de manière que les éléments d'affichage, les échelles et les moyens de correction d'un côté (22) soient libres pour l'observation et la commande, lorsque l'articulation est ouverte et soient dissimulés et protégés par l'autre côté (23), lorsque l'articulation est fermée, et en ce que les deux côtés présentent, à leurs extrémités éloignées de l'articulation, des pointes de contact (31) qui sont reliées de manière électriquement conductrice avec l'appareil de mesure et se situent dans différents plans de pivotement de l'espace, de manière que, lorsque l'articulation est fermée, elles soient situées côte à côte et totalement ou partiellement dissimulées par l'extrémité ouverte de l'autre côté.

Fig.1

Fig.2

Fig.3a

Fig.3b

Fig.3c

**Fig.4**

**Fig.5b**

**Fig.5a**

**Fig.6**

24
25
26
27
28
29
22
23
12 h
30
33
31
31
32
32

Fig.7

23
31
22
33

Fig.8